Europäisches Patentamt

European Patent Office

Office européen des brevets

(11) Publication number: 0 495 113 A1

# EUROPEAN PATENT APPLICATION
## published in accordance with Art. 158(3) EPC

(21) Application number: 91913103.7

(22) Date of filing: 24.07.91

(86) International application number: PCT/JP91/00990

(87) International publication number: WO 92/02048 (06.02.92 92/04)

(51) Int. Cl.5: H01L 27/115

(30) Priority: 24.07.90 JP 195860/90

(43) Date of publication of application: 22.07.92 Bulletin 92/30

(84) Designated Contracting States: DE FR GB IT NL

(71) Applicant: SEIKO EPSON CORPORATION
4-1, Nishishinjuku 2-chome
Shinjuku-ku Tokyo 163(JP)

(72) Inventor: FUJISAWA, Akira
3-5 Owa 3-chome
Suwa-shi, Nagano-ken 392(JP)

(74) Representative: Ouinterno, Giuseppe et al
c/o Jacobacci-Casetta & Perani S.p.A. Via Alfieri, 17
I-10121 Torino(IT)

(54) METHOD OF MANUFACTURING SEMICONDUCTOR DEVICE.

(57) In a semiconductor device in which capacitive elements having ferroelectric layers as their substrates are formed, the increase of the density of the elements is possible, because a connection hole is formed on a diffusion layer (102) of a high concentration, and an electrode (107) and a ferroelectric film (108) are deposited thereon, and thereafter they are made to take predetermined shapes simultaneously by a photolithography technique.

FIG. 1

## FIELD OF THE INVENTION

The present invention relates to a method for forming a semiconductor memory element and more particularly to a nonvolatile semiconductor device having a ferroelectric layer which is electrically polarizable.

## BACKGROUND OF THE INVENTION

A memory device based on electrically polarizable layers has been developed since the early 1950's. Information can be stored by applying a voltage between oppositely arranged upper and lower electrodes (corresponding to the row and column address lines of a typical semiconductor device), thereby polarizing an area intersecting between these electrodes. Further, a reading process can be carried out, for example, by piezoelectrically or pyroelectrically activating some particular memory areas or destructively. In addition, the information can be held permanently due to the residual polarization of the ferroelectric material without being powered by an external electric source.

However, it has been found that circumferential devices, electronic devices necessary for writing and reading the information, are relatively complicated and require a considerably large access time. Accordingly, at the end of the 1970's it was proposed to integrate a ferroelectric memory element directly with a control module, or integrate them together (R, C. Kuck, United States Patent No. 4,149,302 (1979)).

Recently, a memory device having a structure in which a ferroelectric memory and an element are stacked over a MIS-type semiconductor device has been proposed in the IEDM '87 pp 850-857 as shown in application Fig. 6. In Fig. 6, 601 indicates a P-type silicon substrate, 602 indicates a LOCOS oxide film for isolation, and 603 and 604 denote N-type diffusion layers which become a source and drain region, respectively. 605 indicates a gate electrode, and 606 denotes an interlayer insulation film. 608 indicates a ferroelectric film which is interposed between a lower electrode 607 and an upper electrode 609 to form a capacitor.

As described, the stacked structure over the MIS-type semiconductor device requires wiring to connect electrode 607 or 609 to one of highly concentrated diffusion layers 603 or 604. However, there still remains the problem that the area occupied by the element increases.

A general object of the present invention is to solve the afore-mentioned problem of the conventional art and, further, to provide a method for forming a highly integrated semiconductor device at a low cost.

## SUMMARY OF THE INVENTION

A method for forming a semiconductor device in which a capacitor having a ferroelectric material is formed according to the present invention may comprise the steps of:

forming a connecting hole to connect a diffusion layer having a high impurity concentration in a semiconductor substrate to either one of the electrodes which are formed to sandwich the ferroelectric layer;

forming a thin layer which is intended to form an electrode on the surface of a diffusion layer;

forming another thin layer which will become the ferroelectric layer on the thin layer intended to form the electrode;

forming a mask layer on the ferroelectric layer and leaving a portion of the mask layer on a region where a capacitor element is to be formed by using a patterning technique; and

removing simultaneously the thin layer for the ferroelectric layer and the thin layer for the electrode at regions where no capacitor element is formed by using an etching technique and the residual mask layer.

## BRIEF DESCRIPTION OF THE DRAWINGS

Fig. 1 is a sectional view of a semiconductor device having an electrically polarizable ferroelectric layer produced according to a method embodying the present invention;

Figs. 2 to 5 are sectional views showing the main processes for forming a capacitor element of the semiconductor device having an electrically polarizable property according to a method embodying the present invention; and

Fig. 6 is a sectional view of a semiconductor device having an electrically polarizable ferroelectric layer according to the prior art.

## DETAILED DESCRIPTION OF THE PREFERRED EMBODIMENT

Hereinafter, the present invention is described in detail with reference to the accompanying drawings.

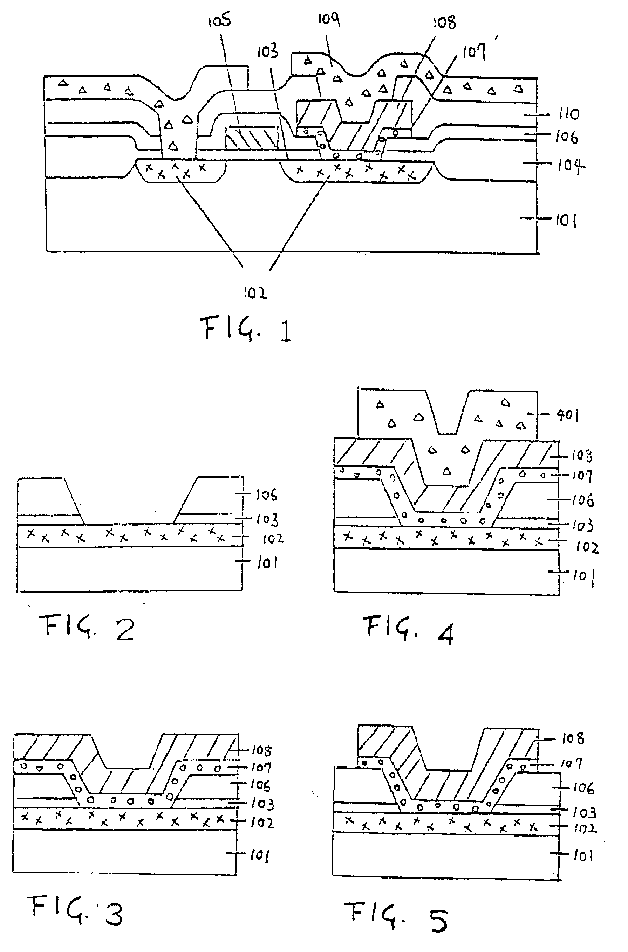

Referring to Fig 1, 101 indicates the substrate of a preferred P-type silicon semiconductor. 102 indicates preferred N-type diffusion layers with a high impurity concentration formed, for example, by ion implantation, which forms a source and a drain region of a MOS transistor. 103 indicates a gate oxide film of a MOS transistor which is preferably formed by a heat oxidization process of the silicon substrate 101. 104 denotes a LOCOS oxide film for isolation. 105 is a gate electrode preferably formed of an N-type polysilicon. 106 and 110 denote respective interlayer insulation films which are preferably formed of $SiO_2$ by using a CVD method. 108 indicates a ferroelectric layer according to the present invention. Ferroelectric layer 108 is preferably formed of $PbTiO_3$, PZT or PLZT. Ferroelectric layer 108 is established on a lower electrode 107 preferably by sputtering a target having an excessive amount of lead in comparison with its stoichiometrical formation. Lower electrode 107 is one of the electrodes having a capacitor element interposed therebetween. A preferred material for lower electrode 107 is platinum and is preferably formed by a sputtering process.

109 indicates an upper electrode making a pair with the lower electrode 107 and is preferably formed by sputtering aluminum. In the present embodiment the aluminum layer serves as upper electrode 109 and a bit line. Of course, upper electrode 109 and the bit line may be formed of different materials and different layers.

In Fig. 1, lower electrode 107 is preferably formed directly on one of the highly concentrated diffusion layers 102 so that areas occupied by wiring can be reduced which results in reducing element areas and realizing high integration.

As shown in Fig. 2, a connecting hole is formed through the interlayer insulation film 106 (preferably of $SiO_2$) and gate oxide film 103 to one of the highly concentrated diffusion layers 102 at a region where the lower electrode 107 is to be formed. This connecting hole preferably has a diameter of 5 $\mu$m, and a preferred thickness of interlayer insulation film 106 is 2000 Å (200 nm). The connecting hole is formed, for example, by carrying out a conventional resist patterning treatment on the interlayer insulation film 106 by a photolithographic technique, then etching interlayer insulation film 106, for example, with hydrofluoric acid.

As shown in Fig. 3, lower electrode 107 is preferably formed by sputtering platinum to a thickness of 1000 Å. Ferroelectric layer 108 is then preferably formed by sputtering PZT to a thickness of 2000 Å (200 nm).

As shown in Fig. 4, a photoresist 401 serving as a mask layer is preferably formed on the ferroelectric thin layer 108 to a thickness of 10,000 Å (1,000 nm). Preferably using a photolithographic technique, a photoresist, which is to become the mask layer, is kept at a region where the capacitor element is to be formed.

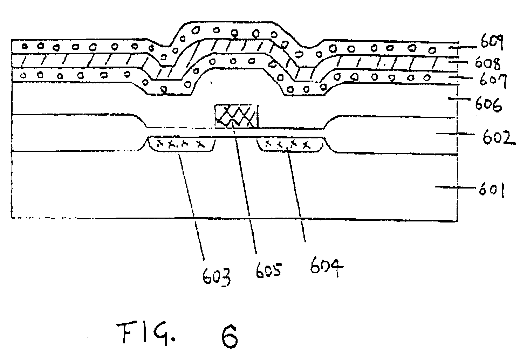

Next, parts of the ferroelectric layer 108 and lower electrode 107 are simultaneously removed, preferably, by a sputter-etching process. Then, by removing the mask layer used as the photoresist, the structure shown in Fig. 5 is obtained.

A final conventional process for forming the structure shown in Fig. 1 is carried out.

As described above, according to the present invention the lower electrode 109 is preferably formed on one of the diffusion layers 102. It becomes possible to provide a nonvolatile semiconductor device having a high integration density. Further, the lower electrode 107 and the ferroelectric layer 108 are simultaneously patterned, and therefore the processes can be simplified.

## Claims

1. A process for forming a semiconductor device in which a capacitor element having as a basic layer a ferroelectric layer is formed, characterized in comprising the steps of:

   forming a connecting hole for connecting a diffusion layer with high impurity concentration of a semiconductor substrate to either of the electrodes formed as to sandwich said ferroelectric layer therebetween;

   forming a thin layer which is intended to form said electrode on the surface of said diffusion layer with a high impurity concentration of said semiconductor device;

   forming another thin layer aimed to form said ferroelectric layer on the surface of said thin layer intended to form said electrode;

   forming a mask layer on said thin ferroelectric thin film, and leaving a portion of the mask layer on a region where a capacitor element is to be formed, by using a patterning technique; and

   removing simultaneously said another thin layer for said ferroelectric layer and said thin layer for said electrode at regions where no capacitor element is formed, by using an etching technique while using said residual mask layer.

2. The method of Claim 1 wherein said connecting hole is formed by patterning a resist with a photolithographic technique and etching with an aqueous solution of hydrofluoric acid to a diameter of 5um.

3. The method of Claim 1 wherein said lower electrode is formed by a sputtering method using Platinum and has a thickness of about 1000 A.

4. The method of Claim 1 wherein said thin film is formed by a sputtering method using PZT and having a thickness of 2000 A.

5. The method of Claim 1 wherein said mask layer is formed to a thickness of 10,000 A.

6. The method of Claim 1 wherein said portion of the mask layer is formed by a photolithographic technique.

7. The method of Claim 1 wherein said lower electrode and said thin layer are removed by a sputter-etching process.

FIG. 1

FIG. 2

FIG. 4

FIG. 3

FIG. 5

FIG. 6

# INTERNATIONAL SEARCH REPORT

International Application No PCT/JP91/00990

## I. CLASSIFICATION OF SUBJECT MATTER (if several classification symbols apply, indicate all) 6

According to International Patent Classification (IPC) or to both National Classification and IPC

Int. Cl$^5$  H01L27/115

## II. FIELDS SEARCHED

| Minimum Documentation Searched 7 | |
|---|---|
| Classification System | Classification Symbols |
| IPC | H01L27/115, 29/792, 29/46 |

| Documentation Searched other than Minimum Documentation to the Extent that such Documents are Included in the Fields Searched 8 |
|---|
| Jitsuyo Shinan Koho  1970 - 1990 |
| Kokai Jitsuyo Shinan Koho  1972 - 1990 |

## III. DOCUMENTS CONSIDERED TO BE RELEVANT 9

| Category* | Citation of Document, 11 with indication, where appropriate, of the relevant passages 12 | Relevant to Claim No. 13 |
|---|---|---|
| Y | JP, A, 1-251760 (Seiko Epson Corp.), October 6, 1989 (06. 10. 89), Line 13, upper right column to line 12, lower left column, page 2 | 1 |
| Y | JP, A, 2-49471 (Toshiba Corp.), February 19, 1990 (19. 02. 90), Line 18, upper left column to line 18, upper right column, page 3 | 1 |
| Y | JP, A, 2-112282 (Olympus Optical Co., Ltd.), April 24, 1990 (24. 04. 90), Lines 5 to 14, lower left column, page 3 | 1 |

* Special categories of cited documents: 10

"A" document defining the general state of the art which is not considered to be of particular relevance

"E" earlier document but published on or after the international filing date

"L" document which may throw doubts on priority claim(s) or which is cited to establish the publication date of another citation or other special reason (as specified)

"O" document referring to an oral disclosure, use, exhibition or other means

"P" document published prior to the international filing date but later than the priority date claimed

"T" later document published after the international filing date or priority date and not in conflict with the application but cited to understand the principle or theory underlying the invention

"X" document of particular relevance; the claimed invention cannot be considered novel or cannot be considered to involve an inventive step

"Y" document of particular relevance; the claimed invention cannot be considered to involve an inventive step when the document is combined with one or more other such documents, such combination being obvious to a person skilled in the art

"&" document member of the same patent family

## IV. CERTIFICATION

| Date of the Actual Completion of the International Search | Date of Mailing of this International Search Report |
|---|---|
| October 21, 1991 (21. 10. 91) | October 28, 1991 (28. 10. 91) |
| International Searching Authority | Signature of Authorized Officer |
| Japanese Patent Office | |

Form PCT/ISA/210 (second sheet) (January 1985)